Europäisches Patentamt

European Patent Office

Office européen des brevets

(19)

(11) Numéro de publication : **0 099 779**
**B1**

(12) # FASCICULE DE BREVET EUROPÉEN

(45) Date de publication du fascicule du brevet :
15.04.87

(21) Numéro de dépôt : 83401288.2

(22) Date de dépôt : 21.06.83

(51) Int. Cl.⁴ : **H 03 B 5/18**

(54) Oscillateur à faible bruit, fonctionnant dans la gamme des hyperfréquences.

(30) Priorité : 02.07.82 FR 8211659

(43) Date de publication de la demande :
01.02.84 Bulletin 84/05

(45) Mention de la délivrance du brevet :
15.04.87 Bulletin 87/16

(84) Etats contractants désignés :
DE GB IT NL SE

(56) Documents cités :
EP-A- 0 013 174
FR-A- 2 376 554
US-A- 3 444 480
US-A- 3 662 285
1981 IEEE MTT-S INTERNATIONAL MICROWAVE
SYMPOSIUM DIGEST, 1981, pages 313-315, IEEE,
New York, USA, Y. KOMATSU et al.: "A frequencystabilized MIC oscillator using a newly-developed
dielectric resonator"
IEEE TRANSACTIONS ON MICROWAVE THEORY
AND TECHNIQUES, vol. MTT-29, no. 12, décembre
1981, pages 1333-1337, IEEE, New York, USA, R.R.
BONETTI et al.: "Analysis of microstrip circuits coupled to dielectric resonators"

(73) Titulaire : THOMSON-CSF
173, Boulevard Haussmann
F-75379 Paris Cedex 08 (FR)

(72) Inventeur : Bert, Alain
THOMSON-CSF SCPI 173, bld Haussmann
F-75379 Paris Cedex 08 (FR)
Inventeur : Camiade, Marc
THOMSON-CSF SCPI 173, bld Haussmann
F-75379 Paris Cedex 08 (FR)

(74) Mandataire : Taboureau, James et al
THOMSON-CSF SCPI 19, avenue de Messine
F-75008 Paris (FR)

EP 0 099 779 B1

Jouve, 18, rue St-Denis, 75001 Paris, France

## Description

La présente invention concerne un oscillateur à faible bruit, fonctionnant dans la gamme des hyperfréquences, et organisé autour d'une pluralité de transistors stabilisés par un unique résonateur diélectrique.

L'invention concerne le domaine dans lequel des transistors fonctionnent en coopération avec des microbandes et des résonateurs diélectriques : elle est applicable aux fréquences relativement basses, telles que 1 ou 2 GHz, avec des transistors bipolaires, mais elle trouve plus particulièrement son intérêt avec les transistors à effet de champ, et à des fréquences plus élevées, telles que 11 à 14 GHz par exemple.

L'utilisation de résonateurs diélectriques, c'est-à-dire de pastilles en matériau diélectrique de valeur élevée, pour stabiliser des oscillateurs à transistors, est bien connue, ainsi que l'intérêt d'une telle stabilisation. De tels dispositifs permettent des stabilités en températures contrôlées par le choix des caractéristiques du matériau du résonateur, et les caractéristiques de bruit près de l'onde porteuse sont particulièrement faibles, en raison des faibles pertes diélectriques des matériaux utilisés à cet effet. Ce type de stabilisation d'un oscillateur permet d'obtenir une fréquence pure par génération directe, sans passer par une chaîne de multiplication de fréquences.

Cependant, dans certaines applications, il est nécessaire de disposer d'une source dont la puissance, à la fréquence considérée, est supérieure à la puissance disponible par un seul transistor ; dans ces mêmes applications il est souvent nécessaire que la puissance soit très stable et que l'oscillateur ne présente qu'un faible bruit parasite autour de la fréquence générée.

Une première solution connue consiste à monter en parallèle une pluralité d'oscillateurs comportant chacun, au moins, un transistor et un stabilisateur par résonateur diélectrique. Mais dans ce cas il est quasiment impossible d'obtenir des résonateurs qui aient tous le même bruit et qui soient tous identiquement couplés avec l'oscillateur. C'est donc une raison pour laquelle un circuit permettant de coupler plusieurs oscillateurs à un même résonateur présente de l'intérêt, de façon à coupler la puissance émise sans additionner pour autant le bruit. Mais si le niveau de puissance n'est pas l'objectif principal recherché, l'accroissement du nombre d'éléments actifs couplés à un même résonateur présente de l'intérêt en ce qui concerne le bruit de l'oscillateur près de la porteuse. La première raison est liée à un accroissement du coefficient $Q_{ext}$, rapport entre l'énergie emmagasinée par périodes dans le résonateur et la puissance fournie à la charge utile. A puissance de sortie donnée, il est possible de coupler davantage d'énergie dans l'unique résonateur. Une seconde raison réside en ce que les signaux hyperfréquences issus des différents transistors s'additionnent en phase, alors que les bruits s'ajoutent de façon non corrélée, c'est-à-dire que le rapport signal sur bruit du dispositif devient meilleur.

Un exemple d'oscillateur hyperfréquence regroupant une pluralité d'éléments semiconducteurs couplés à un résonateur unique est décrit dans le document FR-A-2 376 554. Il s'agit d'un oscillateur dans lequel des diodes à avalanche ou à effet Gunn, présentant une caractéristique de résistance négative, sont groupées, sur un substrat céramique, autour d'un résonateur. Les diodes fonctionnent deux par deux, en alternance de phase, en « push-pull ». Chaque groupe de deux diodes est relié par deux fils aux extrémités d'une microbande déposée sur le substrat, à l'extérieur du résonateur, et couplée avec lui. La puissance de sortie est prélevée par une boucle, supportée par le capot du boîtier d'encapsulation, cette boucle étant couplée avec le résonateur.

Cet oscillateur présente un degré d'intégration moindre que l'oscillateur selon l'invention, ce qui élimine les problèmes de couplage des lignes avec le résonateur. En effet, chaque microbande d'un groupe de deux diodes est à l'extérieur du résonateur, et est connectée par deux fils, qui ne se couplent pas.

En outre, les problèmes de connexions de diodes sont moins aigus que ceux relatifs aux transistors, surtout s'ils sont couplés en entrée et en sortie par deux microbandes et si, comme dans l'invention, le signal de sortie de l'oscillateur est prélevé par microbande, dans le plan du substrat, de façon à intégrer tout l'oscillateur, hormis son unique résonateur.

Par ailleurs, il est connu qu'un seul et unique résonateur peut être couplé à deux électrodes d'un transistor. Par exemple, le brevet FR-A-2 419 609, déposé le 7 mars 1978, au nom de la demanderesse, décrit un oscillateur composé d'un seul transistor, dont la source et la grille sont couplées à un unique résonateur diélectrique, qui en l'occurence est une bille de grenat d'yttrium. Mais il n'y a qu'un seul transistor dans cet oscillateur, et donc pas de problèmes de corrélation de signaux.

L'oscillateur à faible bruit selon l'invention réunit une pluralité de pastilles de transistors montées dans un même boîtier, et groupées autour d'un substrat isolant, ce substrat isolant portant les microbandes associées aux pastilles de transistors. Sur la partie centrale de ce substrat isolant se trouve l'unique résonateur diélectrique, et les microbandes sont dessinées en partie perpendiculaires et en partie parallèles au champ magnétique du résonateur, de telle sorte que seule la longueur de chacune des microbandes qui est perpendiculaire au champ du résonateur est couplée avec lui, les parties parallèles n'étant pas influencées.

De façon plus précise, l'invention concerne un oscillateur à faible bruit fonctionnant dans la gamme des hyperfréquences, comportant une pluralité de transistors stabilisés par un unique résonateur diélectrique couplé à une pluralité de lignes microbandes adaptées, les transistors étant groupés à la périphérie d'une plaque de substrat isolant qui supporte le résonateur diélectrique centré sur le substrat et de dimensions inférieures à celui-ci, cet oscillateur étant caractérisé en ce que, en vue d'additionner en phase les signaux hyperfréquences issus des transistors, chaque transistor a au moins une électrode de commande reliée à une ligne microbande supportée par le substrat, ladite ligne ayant une configuration brisée en U, telle que les deux portions extrêmes de la ligne microbande sont parallèles aux lignes de champ du résonateur et ne lui sont pas couplées, et que la portion centrale de la ligne microbande est perpendiculaire aux lignes de champ magnétique et couplée avec le résonateur.

L'invention sera mieux comprise par la description plus détaillée qui suit d'un exemple de réalisation, celle-ci s'appuyant sur les figures annexées qui représentent :

figure 1    schéma électrique d'un transistor stabilisé par résonateur diélectrique, selon l'art connu

figure 2    variante du schéma précédent

figure 3    vue en plan d'un oscillateur selon l'invention, de configuration circulaire

figure 4    vue en coupe de l'oscillateur de la figure 3 selon l'invention

figure 5    vue de détails montrant l'effet d'une cale d'épaisseur dans un oscillateur selon l'invention

figure 6    variante de l'oscillateur de la figure 3, à sorties de type microruban coplanaire

figure 7    vue en plan d'un oscillateur de configuration rectangulaire.

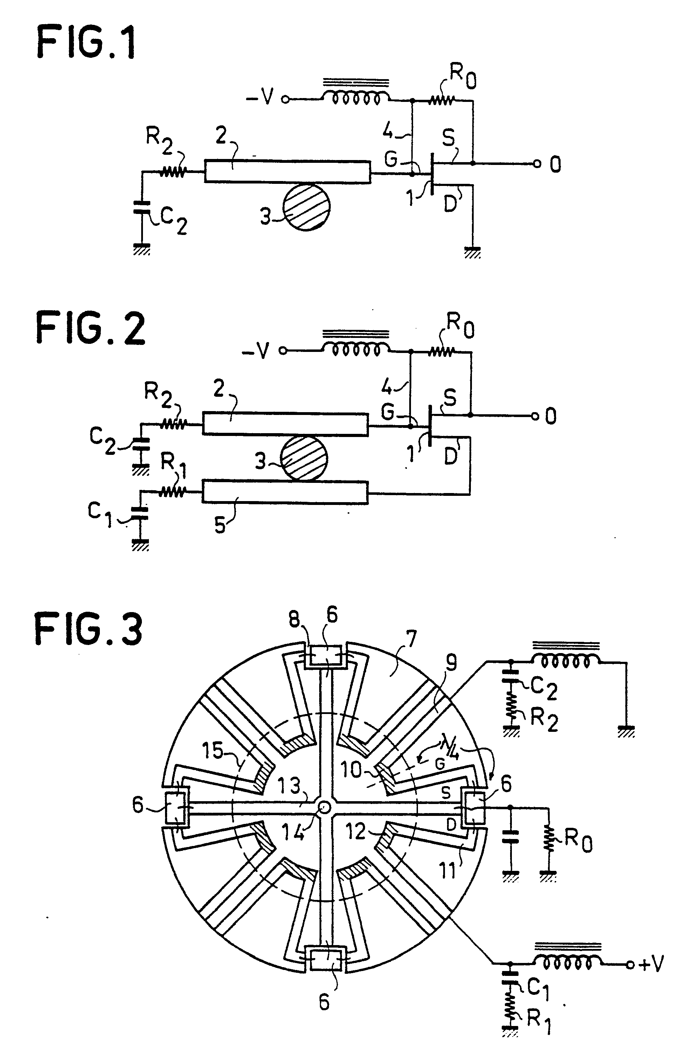

La figure 1 représente le schéma électrique d'un transistor stabilité par résonateur diélectrique, dans une configuration donnant des résultats particulièrement intéressants. Ce schéma est connu. Le transistor représenté est du type à effet de champ mais comme il a été dit, l'invention est applicable également aux transistors bipolaires pour des fréquences plus basses.

Le transistor à effet de champ 1 dont la source, la grille et le drain sont repérés respectivement par S, G et D, est monté en drain commun, ce qui le rend potentiellement instable, et lui permet donc d'osciller dans une gamme de fréquences relativement importante. La grille G est reliée à une ligne microbande 2, à laquelle est couplé un résonateur diélectrique 3. A sa fréquence de résonance, le résonateur diélectrique 3 introduit dans la ligne de grille une impédance très élevée dans le plan de couplage et les conditions d'oscillations peuvent ainsi apparaître pour des positionnements convenables du résonateur 3 le long de la ligne microbande.

L'oscillateur est alimenté à partir d'une tension négative – V sur sa grille par une liaison directe 4 et sur sa source à travers une résistance R0. L'impédance représentée sur la borne d'alimentation schématise le fait que l'alimentation est d'impédance élevée. Dans une version voisine, la tension négative peut être appliquée uniquement sur la source S, la liaison électrique 4 sur la grille étant supprimée, la grille G se fixant à un potentiel convenable par auto-polarisation.

Par ailleurs, une résistance R2 et un condensateur C2 symbolisent la liaison entre la microbande 2 de la grille et la masse électrique.

La figure 2 représente une variante du schéma précédent, les mêmes repères étant conservés pour désigner les mêmes objets de façon à faciliter la comparaison. Cette figure correspond à un oscillateur à transistor dont l'entrée et une sortie — en l'occurrence la grille et le drain — sont couplées par microbandes sur un résonateur unique. Un tel oscillateur est décrit dans le document FR-A-2 419 609 appartenant à la demanderesse.

La variante consiste en ce que le drain D, au lieu d'être réuni à la masse du système, est relié à une deuxième ligne microbande 5 couplée au même résonateur diélectrique 3 que la première ligne microbande 2 de grille G. Ainsi à la fréquence de résonance, et si sa position par rapport au drain est convenablement ajustée, le résonateur diélectrique 3 ramène un court-circuit sélectif au niveau du drain, réalisant les mêmes conditions d'oscillation que dans le schéma de la figure 1, mais de façon plus sélective. Ainsi, l'oscillateur est mieux stabilisé. De la même façon, une résistance R1 et une capacité C1 schématisent la liaison entre la seconde microbande 5 de drain et la masse du dispositif.

Dans les deux cas de figures 1 et 2, le signal de sortie de l'oscillateur est prélevé sur la source, à la borne repérée 0.

Comme cela a déjà été dit, il est toujours possible de grouper une pluralité de tels oscillateurs élémentaires pour obtenir un oscillateur dont la puissance de sortie sur la borne 0 commune soit plus importante. Cependant les résonateurs diélectriques étant des rondelles de matériaux diélectriques dont la constante diélectrique est élevée, supérieure ou égale à 30 par exemple, il est difficile voire impossible de réaliser de telles rondelles dont les caractéristiques soient strictement identiques aux fréquences considérées, c'est-à-dire dans la bande de 11 à 14 GHz. Ainsi, l'addition de plusieurs oscillateurs locaux possédant chacun son résonateur diélectrique permet d'augmenter la puissance de sortie, mais au prix d'un bruit parasite important.

C'est ce qu'évite l'oscillateur de puissance à faible bruit selon l'invention, dont le schéma d'implantation est représenté sur la figure 3, dans une première configuration circulaire.

Cette figure représente un oscillateur à faible bruit groupant une pluralité de transistors à effet de champ montés selon le schéma de principe de la figure 2, c'est-à-dire que grille et drain sont tous deux réunis à des lignes microbandes. Elle représente quatre transistors, mais ni cette précision ni la représentation qui en est donnée ne limitent en quoi que ce soit la portée de l'invention qui s'applique de façon plus générale un oscillateur regroupant une pluralité de transistors.

Les pastilles 6 de transistors sont regroupées autour d'un substrat diélectrique 7, en alumine par exemple, de forme ronde. Il est particulièrement avantageux que ce substrat diélectrique 7 comporte des encoches 8 dans lesquelles viennent se placer les pastilles 6 des transistors à effet de champ car cette disposition facilite le raccordement entre les plots de connexions des pastilles de transistors et les microbandes, déposés sur la face supérieure du substrat diélectrique. Ces raccordements se font par des fils métalliques thermo-soudés.

Des microbandes accordées en fréquence et adaptées en impédance, sont déposées par des méthodes de couches minces ou de couches épaisses à la surface du substrat diélectrique 7. Mais ces microbandes sont, s'il est nécessaire de les coupler au résonateur, en forme de U, et elles comportent alors deux sections radiales, et une section concentrique au substrat diélectrique 7. Trois microbandes sont ainsi réalisées pour chaque transistor à effet de champ : la microbande 9 est dans le cas représenté sur la figure 3 réunie par un fil métallique à la grille d'un transistor 6 ; elle est en forme de U et seule sa portion centrale 10, concentrique au disque est couplée avec le résonateur. De la même façon, la microbande 11 est réunie par un fil métallique au plot de drain du même transistor 6 et seule sa portion centrale 12 est couplée au résonateur. Enfin, la microbande 13, réunie au plot de source du transistor, est entièrement radiale : elle n'est donc pas couplée au résonateur et sert de sortie par le coaxial central 14. Le cercle 15, représenté en pointillés schématise la trace sur le plan du substrat diélectrique, du résonateur diélectrique qui est posé sur l'ensemble.

Dans son fondement, cette disposition avec des portions de microbandes radiales et des portions de ces mêmes microbandes concentriques par rapport au substrat diélectrique et, simultanément, par rapport au résonateur diélectrique 15, est liée au fait que seules se couplent au champ magnétique du résonateur les portions de lignes qui sont circulaires c'est-à-dire celles qui ont été décrites comme étant concentriques par rapport au résonateur. Toutes les portions radiales ne se couplent pas et la propagation s'y comporte comme si le résonateur était absent. On localise ainsi les zones de couplage aux distances convenables par rapport aux transistors, généralement de l'ordre de $\lambda/4$, $\lambda$ étant la longueur d'onde de propagation sur la ligne microbande : cette longueur $\lambda/4$ est donc celle qui va depuis le plot de connexion d'un transistor, la grille par exemple, jusqu'au milieu de la portion de ligne couplée au résonateur.

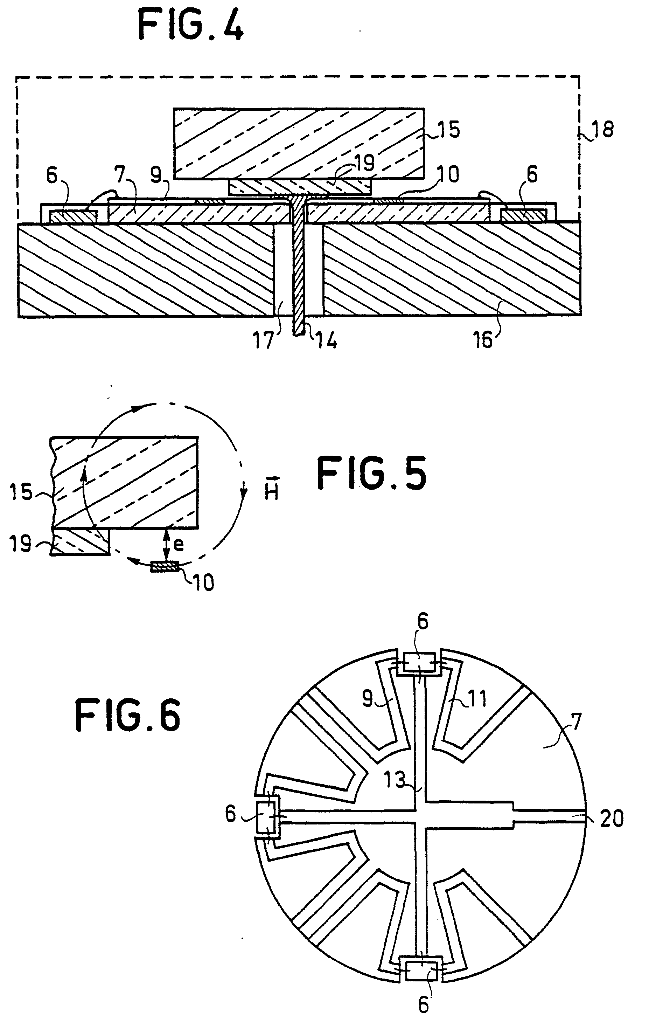

Dans la représentation adoptée pour la figure 3, c'est-à-dire grille et drain étant couplés au même résonateur diélectrique, le diamètre du substrat diélectrique est calculé pour que, le diamètre du résonateur diélectrique 15 étant donné et la longueur totale $\lambda/2$ des microbandes étant également donnée par la fréquence de travail, les zones de couplage 10 et 12, représentées hachurées sur cette figure, soient à une distance du centre inférieure au rayon du résonateur 15, de façon à optimiser le couplage entre le champ magnétique du résonateur 15 et les zones de couplage 10 et 12 des microbandes. Ce détail sera exposé à l'occasion de la figure 5. Par ailleurs, le résonateur est placé dans des conditions de résonance qui optimisent le rendement de l'oscillateur, et il fonctionne selon un mode qui est connu de l'homme de l'art sous l'appelation $TE_{01\delta}$.

Par ailleurs, dans le cas de figure ici représentée et qui correspond à la figure 2, on a adopté la solution avantageuse qui consiste à alimenter le drain par une tension positive, plutôt que de mettre la source sous une tension négative : il est connu que les alimentations positives sont plus facilement disponibles que les alimentations négatives. La grille est reliée électriquement à la masse pour le continu, et la source est autopolarisée grâce à la résistance R0.

Une variante de l'oscillateur selon l'invention permet d'obtenir facilement un schéma conforme au schéma de principe de la figure 1. Si par exemple on ne désire pas que le drain soit couplé à l'unique résonateur par une ligne microbande, la ligne de sortie 11 ne comporte pas de section radiale et va directement sur le bord du substrat diélectrique pour mise à la masse, ou dans le cas présent pour alimentation par une tension positive.

La figure 4, en montrant une vue en coupe de l'oscillateur selon l'invention, permettra de mieux en comprendre la structure.

Cet oscillateur est réalisé sur une embase métallique 16, qui sert également de fond de boîtier d'encapsulation, le boîtier étant refermé par un couvercle schématisé par une ligne pointillée 18, le problème de l'encapsulation entre un fond de boîtier 16 et un couvercle 18 sortant du domaine de l'invention, et étant à la portée de l'homme de l'art qui choisira, selon les besoins, une encapsulation céramique ou métallique. Le fond de boîtier métallique 16 sert de plan de masse pour le dispositif hyperfréquences encapsulé, et dans le cas présent il est percé en son centre d'un orifice 17 à travers lequel passe le câble coaxial de sortie 14. Sur ce fond de boîtier est disposé le substrat diélectrique 7, et, selon le plan de coupe choisi, on voit deux pastilles de transistors 6. La face supérieure, c'est-à-dire la face libre du substrat diélectrique 7, supporte les lignes microbandes, en particulier la ligne microbande 9 de grille d'un transistor 6 et sa zone de couplage 10. Le résonateur diélectrique 15 est posé par dessus l'ensemble des lignes microbandes, et centré par rapport au substrat et par rapport au coaxial de sortie. Mais il est supporté par une cale d'épaisseur 19, d'épaisseur inférieure ou égale à 0,5 mm, qui est en matériau diélectrique à faible coefficient $\varepsilon \leq 9$, cette cale étant destinée à optimiser le couplage et le rendement de l'oscillateur. Pour ce faire, elle est réglable en épaisseur, c'est-à-dire qu'en fait elle est usinée ou rôdée jusqu'à obtenir une épaisseur qui donne un couplage optimum pour l'oscillateur.

La figure 5 montre un détail agrandi du couplage entre un élément de microbande 10 et le résonateur 15. Le champ magnétique H issu du résonateur est optimum dans la microbande accordée 10 en présence de la cale d'épaisseur 19 qui amène ainsi un écart « e » entre la face inférieure du résonateur 15 et la face supérieure de la ligne microbande. L'oscillateur à faible bruit selon l'invention fonctionnerait également sans la cale d'épaisseur 19, mais il serait moins bien accordé et optimisé.

La figure 6 représente une variante de l'oscillateur selon l'invention tel qu'il a été représenté en figure 3. L'oscillateur de la figure 3 comportait une sortie centrale au boîtier, par l'intermédiaire d'un coaxial : l'oscillateur de la figure 6 comporte une sortie coplanaire, par l'intermédiaire d'une microbande 20 portée par le substrat diélectrique 7 dans le même plan que les autres microbandes du dispositif.

Il est bien entendu que la représentation de la figure 6 peut tout aussi bien être tirée directement de la représentation de la figure 3 en resserrant entre eux, dans la mesure du possible, les transistors et leurs microbandes supportées par le substrat diélectrique 7 et en faisant passer la ligne de sortie 20 entre deux microbandes de grille et de drain des transistors de l'oscillateur.

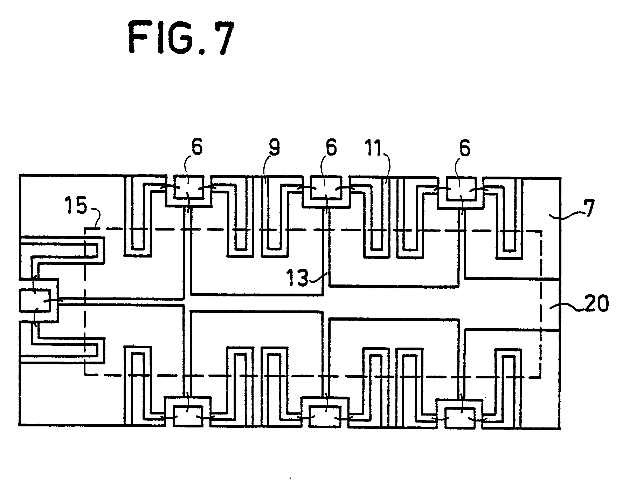

La figure 7 représente une vue en plan d'un oscillateur selon l'invention, dans une configuration linéaire, rectangulaire mais qui peut tout aussi bien être carrée.

Le fonctionnement d'un tel dispositif est identique à celui qui a été décrit en s'appuyant sur une configuration circulaire, mais, dans certains cas, il peut être avantageux de disposer d'une telle configuration linéaire et d'un boîtier rectangulaire.

Bien qu'elle soit simplifiée, cette figure montre que les transistors 6 sont regroupés autour d'un substrat 7 rectangulaire, dans des encoches 8. L'unique résonateur diélectrique 15, rectangulaire, est représenté par sa trace en pointillés. Les microbandes 9, 11, 13 ne sont plus radiales ou concentriques, mais perpendiculaires ou parallèles au bord du résonateur.

Une sortie 20 coplanaire en microbande est représentée sur cette figure 7, mais une sortie centrale par câble coaxial appartient au domaine de l'invention.

La structure rectangulaire de la figure 7 se prête particulièrement bien à l'intégration de l'oscillateur sur une plaquette monolithique, le substrat isolant 7 étant alors une plaquette de matériau semiconducteur rendu isolant par dopage.

L'oscillateur est dans ce cas composé — hormis son boîtier — d'un résonateur unique et d'une plaquette monolithique, isolante, sur la périphérie de laquelle sont réalisés les transistors, par des méthodes connues — diffusion, implantation...etc — et à la surface de laquelle sont déposées les lignes microbandes adaptées. La sortie est dans ce cas préférentiellement réalisée par microbande coplanaire.

Une telle disposition monolithique est intéressante aux fréquences élevées, vers 30 GHz, car les dimensions des lignes microbandes sont alors telles qu'elles rendent le dispositif compatible avec la découpe d'une plaquette de quelques millimètres de côté — environ 2 mm —. A ces fréquences, l'association de plusieurs transistors à effet de champ se justifie d'autant plus que leur puissance est faible.

A titre d'exemple, un oscillateur selon l'invention fournit 100 milliwatts à 11 GHz.

En outre, le fait de changer de type de transistors ou d'adapter les matériaux tels qu'ils ont été décrits dans le texte présent appartient au domaine de l'invention, qui consiste essentiellement à coupler une pluralité de transistors sur un seul et unique résonateur diélectrique, et qui est précisé par les revendications ci-après.

**Revendications**

1. Oscillateur à faible bruit fonctionnant dans la gamme des hyperfréquences, comportant une pluralité de transistors stabilisés par un unique résonateur diélectrique couplé à une pluralité de lignes microbandes adaptées, les transistors (6) étant groupés à la périphérie d'une plaque de substrat isolant (7) qui supporte le résonateur diélectrique (15) centré sur le substrat (7) et de dimensions inférieures à celui-ci, cet oscillateur étant caractérisé en ce que, en vue d'additionner en phase les signaux hyperfréquences issus des transistors, chaque transistor (6) a au moins une électrode de commande reliée à une ligne microbande (9) supportée par le substrat (7), ladite ligne ayant une configuration brisée en U, telle que les deux portions extrêmes de la ligne microbande sont parallèles aux lignes de champ du résonateur (15) et ne lui sont pas couplées, et que la portion centrale (10) de la ligne microbande est perpendiculaire aux lignes de champ magnétique et couplée avec le résonateur.

2. Oscillateur à faible bruit selon la revendication 1, caractérisé en ce que les transistors (6) sont des transistors à effet de champ, stabilisés sur leur électrode de grille (G) par une ligne microbande (9 + 10) couplée à l'unique résonateur (15).

3. Oscillateur à faible bruit selon la revendication 2, caractérisé en ce que les transistors (6) sont en outre stabilisés sur leur électrode de drain (D) par une ligne microbande (11 + 12) couplée à l'unique résonateur (15).

4. Oscillateur à faible bruit selon la revendication 1, caractérisé en ce que le substrat (7) étant circulaire, le résonateur (15) est également circulaire, les portions extrêmes des lignes microbandes (9, 11) sont radiales, et les portions (10, 12) des lignes, couplées à l'unique résonateur (15), sont disposées en un cercle de diamètre inférieur au diamètre du résonateur.

5. Oscillateur à faible bruit selon la revendication 1, caractérisé en ce que le substrat isolant (7) étant rectangulaire, le résonateur (15) est également rectangulaire, les portions extrêmes des lignes microbandes (9, 11) sont perpendiculaires aux bords du substrat (7) et les portions (10, 12) des lignes, couplées à l'unique résonateur (15), sont parallèles aux bords du substrat (7) et du résonateur (15).

6. Oscillateur à faible bruit selon la revendication 1, caractérisé en ce que le substrat isolant (7) plan, comporte sur sa périphérie des encoches (8) dans lesquelles sont positionnées les pastilles des transistors (6) et en ce que les lignes microbandes (9, 11), partant des bords de ces encoches (8), sont coplanaires aux transistors (6).

7. Oscillateur à faible bruit selon la revendication 6, caractérisé en ce que le signal de sortie de l'oscillateur, prélevé sur la source (S) de chacun des transistors (6) par l'intermédiaire d'une ligne (13), est délivrée au centre du substrat (7) par une ligne coaxiale (14), perpendiculaire au plan du substrat (7).

8. Oscillateur à faible bruit selon la revendication 6, caractérisé en ce que le signal de sortie de l'oscillateur, prélevé sur la source (S) de chacun des transistors (6) par l'intermédiaire d'une ligne (13), est délivré sur le bord du substrat (7) par une ligne (20) adaptée en impédance et coplanaire au plan du substrat (7) et des lignes microbandes (9, 11, 13).

9. Oscillateur à faible bruit selon l'une quelconque des revendications 1 à 8, caractérisé en ce qu'une cale (19), en matériau diélectrique à faible constante ($\varepsilon \leq 9$) et d'épaisseur réglable, est intercalée entre le résonateur (15) et les portions couplées (10, 12) des lignes, en vue d'optimiser le couplage ligne/résonateur et d'améliorer le rendement de l'oscillateur.

10. Oscillateur à faible bruit selon la revendication 1, caractérisé en ce que les transistors (6), les lignes microbandes (9, 11, 13, 20) et le substrat isolant (7) sont monolithiques, les transistors (6) étant réalisés dans une plaquette de matériau semiconducteur rendu isolant par dopage, et les lignes microbandes (9, 11, 13, 20) étant déposées sur cette plaquette.

11. Oscillateur à faible bruit selon l'une quelconque des revendications 1 à 9, caractérisé en ce qu'il est monté dans un boîtier d'encapsulation dont le fond métallique (16) sert de plan de masse aux lignes microbandes.

**Claims**

1. Low noise microwave oscillator, comprising a plurality of transistors stabilized by a common dielectric resonator which is coupled to a plurality of matched microstrip lines, the transistors (6) being arranged in the peripheral zone of an insulating substrate (7) supporting the dielectric resonator (15) which is centered on the substrate (7) and has a smaller size than the substrate, characterized in that, in order to add in phase the microwave signals generated by the transistors, each transistor (6) has at least one control electrode connected to a microstrip line (9) supported by the substrate (7), said line having a U-shaped broken shape such that the two end portions of the microstrip line are parallel to the field lines of the resonator (15) and are not coupled thereto, whereas the central portion (10) of the microstrip line is disposed perpendicularly to the magnetic field lines and is coupled to the resonator.

2. A low noise oscillator according to claim 1, characterized in that the transistors (6) are field effect transistors which are stabilized on their gate electrode (G) by a microstrip line (9 + 10) coupled to the common resonator (15).

3. A low noise oscillator according to claim 2, characterized in that the transistors (6) are further stabilized on their drain electrode (D) by a microstrip line (11 + 12) coupled to the common resonator (15).

4. A low noise oscillator according to claim 1, characterized in that, the substrate (7) being circular, the resonator (15) is also circular, the end portions of the microstrip lines (9, 11) are radial and the line portions (10, 12) coupled to the common resonator (15) are disposed in a circle, the diameter of which is smaller than the diameter of the resonator.

5. A low noise oscillator according to claim 1, characterized in that the insulating substrate (7) being rectangular, the resonator (15) is also rectangular, the end portions of the microstrip lines (9, 11) are disposed perpendicularly to the edges of the substrate (7) and the line portions (10, 12) coupled to the common resonator (15) are parallel to the edges of the substrate (7) and of the resonator (15).

6. A low noise oscillator according to claim 1, characterized in that the plane insulating substrate (7) comprises in its peripheral zone notches (8) in which the transistor dices (6) are positioned, and that the microstrip lines (9, 11) originating at the edges of these notches (8) are coplanar to the transistors (6).

7. A low noise oscillator according to claim 6, characterized in that the outptut signal of the oscillator taken at the source (S) of each one of the transistors (6) *via* a line (13) is supplied to the center of the substrate (7) *via* a coaxial line (14) which is perpendicular to the plane of the substrate (7).

8. A low noise oscillator according to claim 6, characterized in that the output signal of the oscillator taken at the source (S) of each one of the transistors (6) *via* a line (13) is supplied to the edge of the substrate (7) *via* a line (20) which is impedance matched and coplanar to the plane of the substrate (7) and of the microstrip lines (9, 11, 13).

9. A low noise oscillator according to any one of claims 1 to 8, characterized in that a choke (19) of a dielectric material having a low dielectricity factor ($\varepsilon \leq 9$) and adjustable thickness is interposed between the resonator (15) and the coupled line portions (10, 12) in order to optimize the coupling between line and resonator and to improve the efficiency of the oscillator.

10. A low noise oscillator according to claim 1, characterized in that the transistors (6), the microstrip lines (9, 11, 13, 20) and the insulating substrate (7) are monolithic, the transistors (6) being realized in a chip of semiconductor material which is rendered insulating by doping, whereas the microstrip lines (9, 11, 13, 20) are deposited on this chip.

11. A low noise oscillator according to any one of claims 1 to 9, characterized in that it is mounted in an encapsulation casing, the metal bottom (16) of which constitutes a mass plane for the microstrip lines.


**Patentansprüche**

1. Rauscharmer Mikrowellenoszillator, mit einer Mehrzahl von durch einen einzigen an eine Mehrzahl von angepaßten Mikrostripleitungen gekoppelten dielektrischen Resonator stabilisierten Transistoren (6), die am Rand einer Platte (7) aus isolierenden Substrat gruppiert sind, wobei der dielektrische Resonator (15) im Zentrum des Substrats (7) sitzt und geringere Abmessungen als das Substrat aufweist, dadurch gekennzeichnet, daß jeder Transistor (6) zur phasenmäßigen Addition der von den Transistoren kommenden Mikrowellensignale mindestens eine Steuerelektrode besitzt, die mit einer auf dem Substrat (7) angebrachten Mikrostripleitung (9) verbunden ist, wobei diese Leitung eine gebrochene Konfiguration in Form eines U besitzt, derart, daß die beiden Endbereiche der Mikrostripleitung parallel zu den Feldlinien des Resonators (15) verlaufen und an diesen nicht gekoppelt sind, während der zentrale Bereich (10) der Mirkostripleitung senkrecht zu den magnetischen Feldlinien verläuft und mit dem Resonator gekoppelt ist.

2. Rauscharmer Oszillator nach Anspruch 1, dadurch gekennzeichnet, daß die Transistoren (6) Feldeffekttransistoren sind, die an ihrer Gateelektrode (G) von einer mit dem einzigen Resonator (15) gekoppelten Mikrostripleitung (9 + 10) stabilisiert ist.

3. Rauscharmer Oszillator nach Anspruch 2, dadurch gekennzeichnet, daß die Transistoren (6) außerdem an ihrer Drainelektrode (D) durch eine an den einzigen Resonator (15) gekoppelte Mikrostripleitung (11 + 12) stabilisiert sind.

4. Rauscharmer Oszillator nach Anspruch 1, dadurch gekennzeichnet, daß für ein Substrat (7), das kreisförmig ist, der Resonator (15) ebenfalls kreisförmig ist, die Endbereiche der Mikrostripleitungen (9, 11) radial verlaufen und die an den einzigen Resonator (15) gekoppelten Bereiche (10, 12) der Leitungen in einem Kreis angeordnet sind, dessen Durchmesser geringer als der Durchmesser des Resonators ist.

5. Rauscharmer Oszillator nach Anspruch 1, dadurch gekennzeichnet, daß für ein isolierendes Substrat (7) mit Rechteckform der Resonator (15) ebenfalls rechteckig ist, während die Endbereiche der Mikrostripleitungen (9, 11) senkrecht zu den Rändern des Substrats (7) verlaufen und die an den einzigen Resonator (15) gekoppelten Bereiche (10, 12) der Leitungen parallel zu den Rändern des Substrats (7) und des Resonators (15) verlaufen.

6. Rauscharmer Oszillator nach Anspruch 1, dadurch gekennzeichnet, daß das ebene isolierende Substrat (7) auf seinem Umfang Einschnitte (8) aufweist, in denen die Transistorplättchen (6) liegen, und daß die Mikrostripleitungen (9, 11) die von den Rändern dieser Einschnitte (8) ausgehen, in derselben Ebene wie die Transistoren (6) liegen.

7. Rauscharmer Oszillator nach Anspruch 6, dadurch gekennzeichnet, daß das Ausgangssignal des Oszillators, das an der Sourceelektrode (S) jedes der Transistoren (6) über eine Leitung (13) abgegriffen wird, über eine Koaxialleitung (14), die senkrecht zur Ebene des Substrats (7) verläuft, zum Zentrum des Substrats geliefert wird.

8. Rauscharmer Oszillator nach Anspruch 6, dadurch gekennzeichnet, daß das Ausgangssignal des Oszillators, das an der Sourceelektrode (S) jedes der Transistoren (6) über eine Leitung (13) abgegriffen wird, an den Rand des Substrats (7) über eine in ihrer Impedanz angepaßte und zur Ebene des Substrats (7) und der Mikrostripleitungen (9, 11, 13) koplanare Leitung (20) geliefert wird.

9. Rauscharmer Oszillator nach einem beliebigen der Ansprüche 1 bis 8, dadurch gekenzeichnet, daß ein Zwischenstück (19) aus dielektrischem Material mit niedriger Dielektrizitätskonstante ($\varepsilon \leqslant 9$) und regelbarer Dicke zwischen den Resonator (15) und die gekoppelten Bereiche (10, 12) der Leitungen eingefügt ist, um die Kopplung zwischen Leitung und Resonator optimal zu gestalten und den Wirkungsgrad des Oszillators zu verbessern.

10. Rauscharmer Oszillator nach Anspruch 1, dadurch gekennzeichnet, daß die Transistoren (6), die Mikrostripleitungen (9, 11, 13, 20) und das isolierende Substrat (7) monolithisch sind und die Transistoren (6) auf einem Chip aus Halbleitermaterial realisiert sind, das durch Dotierung isolierend gemacht ist, während die Mikrostripleitungen (9, 11, 13, 20) auf dieses Chip aufgebracht sind.

11. Rauscharmer Oszillator nach einem beliebigen der Ansprüche 1 bis 9, dadurch gekennzeichnet, daß er in einem Kapselgehäuse montiert ist, dessen metallischer Boden (16) als Masse-ebene für die Mikrostripleitungen dient.

# FIG.1

# FIG.2

# FIG.3

1

0 099 779

# FIG.4

# FIG.5

# FIG.6

2

# FIG.7